# EUROPEAN PATENT APPLICATION

(11) **EP 4 472 190 A1**
(43) Date of publication of application: **04.12.2024**
(21) Application number: 23743216.6
(22) Date of filing: 16.01.2023
(51) Int. Cl.: H04N 5/64

(54) **HEAD-MOUNTED DISPLAY**

(30) Priority: 24.01.2022 JP 2022008699
(71) Applicant: Sony Interactive Entertainment Inc., Tokyo 108-0075 (JP)
(72) Inventor: OTSUKA, Yoshiyuki, Tokyo 108-0075 (JP)
(74) Representative: D Young & Co LLP
(86) International application number: PCT/JP2023/001008
(87) International publication number: WO 2023/140222

(57) **Abstract**

An HMD (1) that suppresses a temperature rise in the apparatus main body (10) efficiently is provided. The HMD (1) includes a main body housing (11) that accommodates at least a display panel (13), a right lens (122R), and a left lens (122L) therein, a mounting band (20) that supports the main body housing (11) and is mounted on the head of a user, and a duct (50) accommodated in the main body housing (11) and configuring part of a flow path that discharges air in the main body housing (11) to the outside thereof.

## Description

### [Technical Field]

The present invention relates to a head-mounted display.

### [Background Art]

As disclosed in PTL 1, a head-mounted display includes an apparatus main body in which a display is built and a band that surrounds the head of a user. In the head-mounted display, the temperature in the apparatus main body sometimes may rise due to generation of heat in various devices mounted in the apparatus main body. The head-mounted display disclosed in PTL 1 adopts a configuration that includes a fan built in the apparatus main body so as to suppress the temperature rise in the apparatus main body.

### [Citation List]

### [Patent Literature]

[PTL 1]
US 2018/0307282

### [Summary]

### [Technical Problem]

Here, in the head-mounted display, a contrivance for further suppressing the temperature rise in the apparatus main body is demanded.

One of objects of the present specification is to provide a head-mounted display that efficiently suppresses a temperature rise in an apparatus main body.

### [Solution to Problem]

An example of a head-mounted display proposed in the present disclosure includes a main body housing that accommodates at least a display panel and a lens therein, a mounting band that supports the main body housing and that is mounted on a head of a user, and a duct accommodated in the main body housing and configuring part of a flow path that discharges air in the main body housing to an outside thereof.

With the head-mounted display described above, the temperature rise in the apparatus main body can be suppressed efficiently.

### [Brief Description of Drawings]

[FIG. 1]

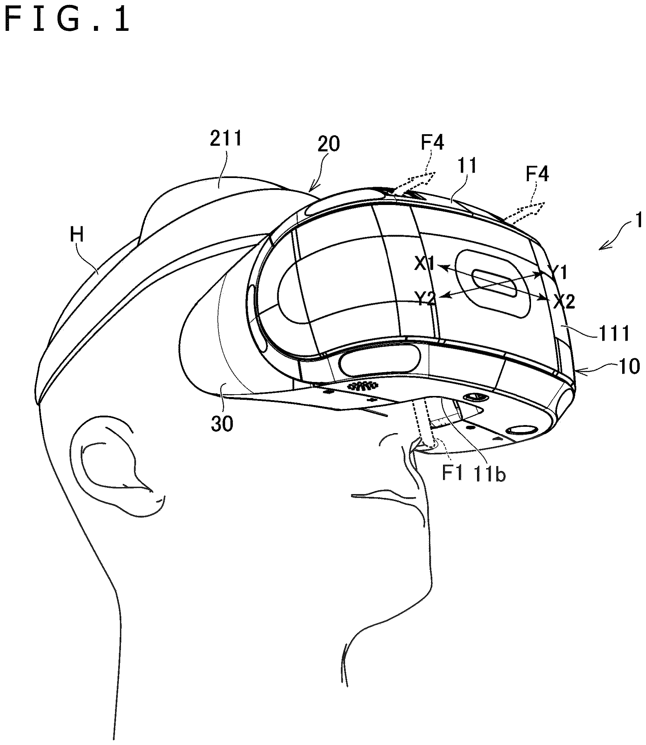

   FIG. 1 is a perspective view depicting a state in which an HMD according to the present embodiment is being used and is a perspective view of the HMD as viewed diagonally from the lower front side.
[FIG. 2]

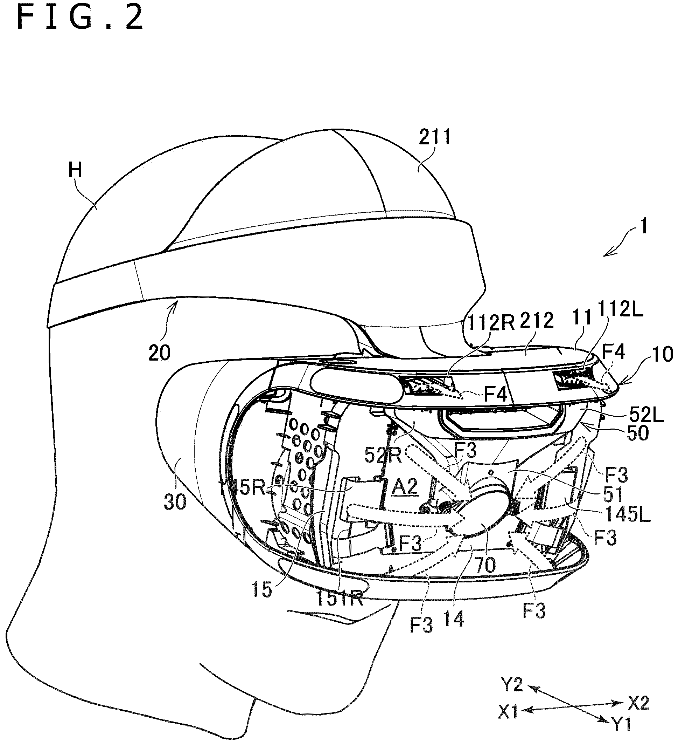

   FIG. 2 is a perspective view depicting a state in which the HMD according to the present embodiment is being used and is a perspective view of the HMD as viewed diagonally from the upper front side.
[FIG. 3]

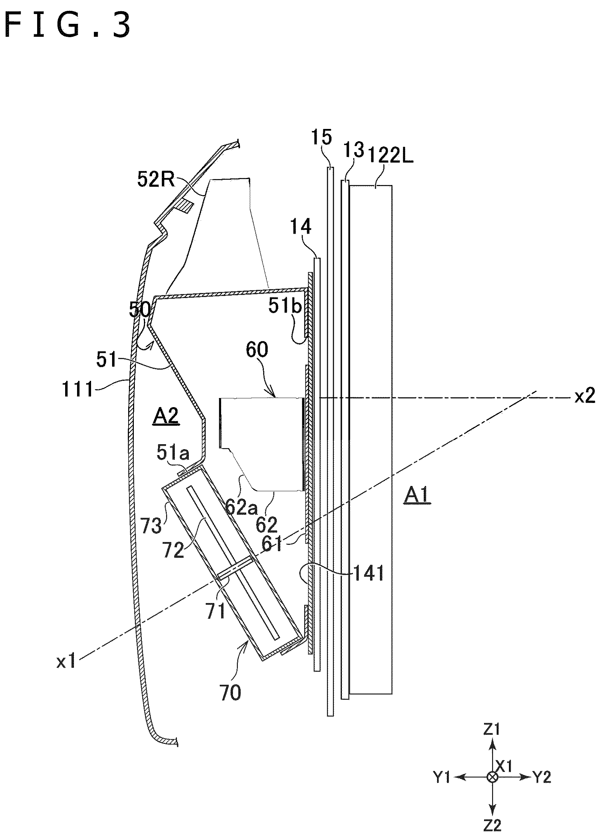

   FIG. 3 is a cross sectional view schematically depicting a state in which a cross section of an apparatus main body of the HMD according to the present embodiment is viewed from the left side.
[FIG. 4]

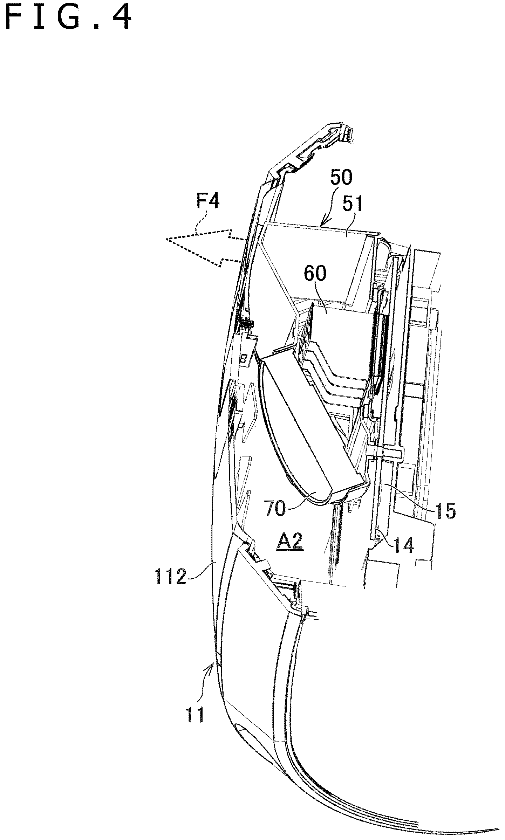

   FIG. 4 is a cross sectional perspective view depicting a state in which a cross section of the apparatus main body of the HMD according to the present embodiment is viewed from the left side.
[FIG. 5]

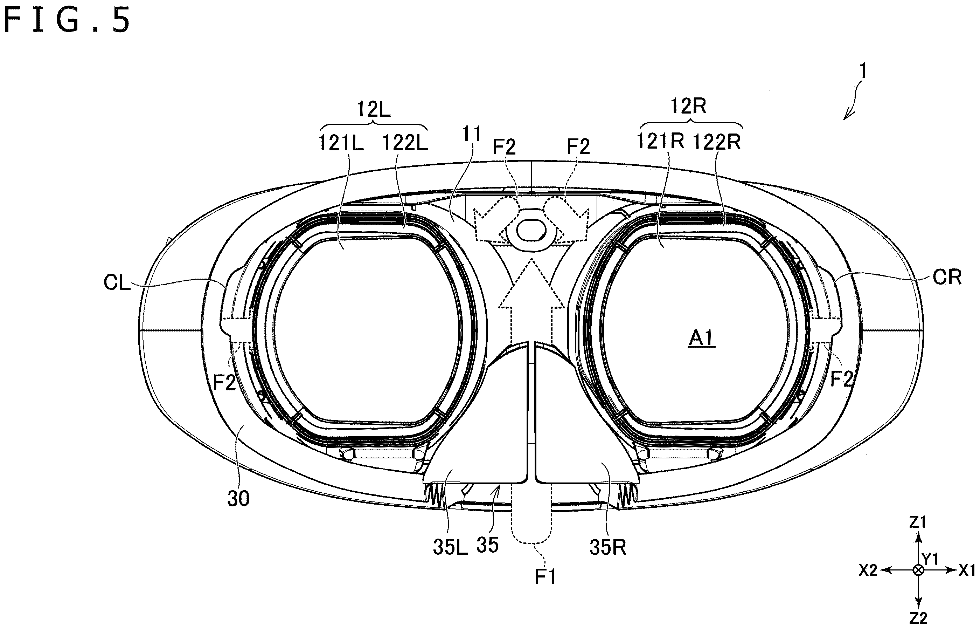

   FIG. 5 is a rear elevational view of the HMD according to the present embodiment as viewed from the rear.
[FIG. 6]

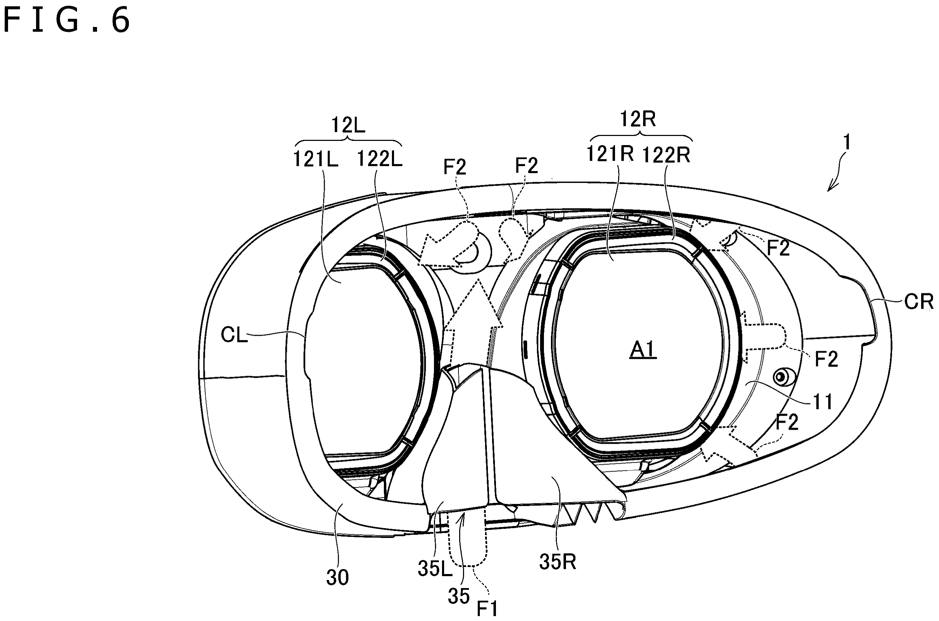

   FIG. 6 is a rear elevational perspective view of the HMD according to the present embodiment as viewed diagonally from the rear side.
[FIG. 7]

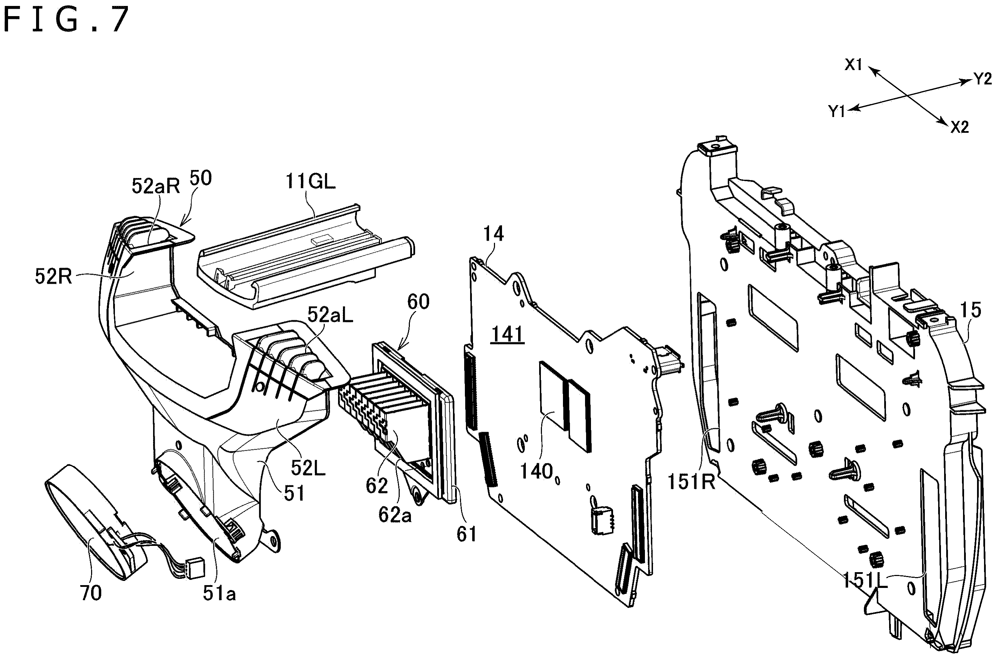

   FIG. 7 is an exploded perspective view of a duct and members arranged around the duct as viewed diagonally from the front side.
[FIG. 8]

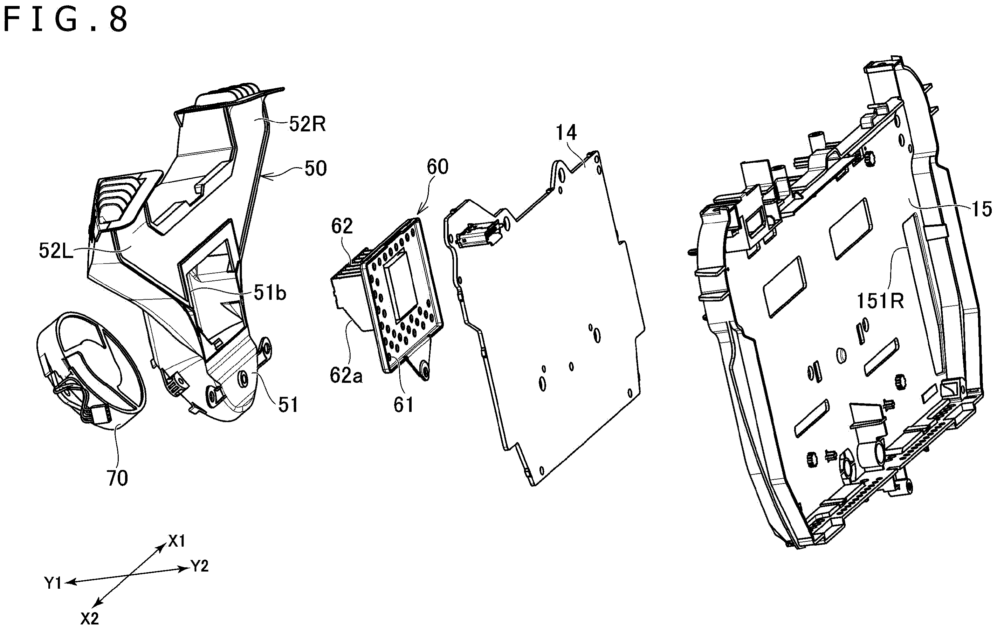

   FIG. 8 is an exploded perspective view of the duct and the members disposed around the duct as viewed diagonally from the rear side.

### [Description of Embodiments]

In the following, an embodiment of the present invention is described with reference to the drawings. In the following description, directions indicated by reference signs X1 and X2 in the figures are defined as a rightward direction and a leftward direction, respectively. Directions indicated by reference signs Y1 and Y2 in the figures are defined as a forward direction and a rearward direction, respectively. Directions indicated by reference signs Z1 and Z2 in the figures are defined as an upward direction and a downward direction, respectively. These directions indicate directions as viewed from a user who wears a head-mounted display 1. Further, in the following description, the head-mounted display 1 is referred to as an HMD (Head Mounted Display) 1.

In the drawings, a broken line arrow mark indicates a direction in which air flows. Further, in the present embodiment, a space formed between the face of a user who wears the HMD 1 and a light blocking member 30 (sometimes referred to as a light shield) hereinafter described is referred to as a "first space 1A." Further, a space in a main body housing 11 in front of a support wall 15 hereinafter described is referred to as a "second space A2." The first space 1A is a space outside the HMD 1, and the second space A2 is a space inside the HMD 1 (apparatus main body 10).

The HMD 1 according to the present embodiment adopts a configuration that allows air staying in the first space 1A to move to the second space A2 and further discharges the air from the second space A2 to the outside of the HMD 1.

### <Outline of General Configuration of HMD 1>

First, an outline of a general configuration of the HMD 1 according to the present embodiment is described with reference to FIGS. 1 to 6. FIG. 1 is a perspective view depicting a state in which the HMD according to the present embodiment is being used and is a perspective view of the HMD as viewed diagonally from the lower front side. FIG. 2 is a perspective view depicting a state in which the HMD according to the present embodiment is being used and is a perspective view of the HMD as viewed diagonally from the upper front side. FIG. 3 is a cross sectional view schematically depicting a state in which a cross section of the apparatus main body of the HMD according to the present embodiment is viewed from the left side. FIG. 4 is a cross sectional perspective view depicting a state in which a cross section of the apparatus main body of the HMD according to the present embodiment is viewed from the left side. FIG. 5 is a rear elevational view of the HMD according to the present embodiment as viewed from the rear. FIG. 6 is a rear elevational perspective view of the HMD according to the present embodiment as viewed diagonally from the rear. It is to be noted that, in FIG. 2, a front cover 111 of a main body housing 11 is omitted. In FIGS. 3 and 4, a cross section that passes an intake pipe portion 51 of a duct 50 hereinafter described is depicted. It is to be noted that, in FIG. 3, slanting lines are applied to only part of cross sections in order to avoid complication of illustration.

As depicted in FIGS. 1 and 2, the HMD 1 includes the apparatus main body 10, a mounting band 20, and a light blocking member 30.

The apparatus main body 10 includes at least a right optical unit 12R and a left optical unit 12L, a display panel 13, and a main body housing 11 that accommodates them therein and configures an exterior of the apparatus main body 10. Although the display panel 13 may be, for example, a liquid crystal display device or an organic electroluminescence display device, the type of the display panel 13 is not restricted specifically.

As depicted in FIGS. 5 and 6, the right optical unit 12R includes a right lens 121R that introduces image light from the display panel 13 to the right eye of the user, and a tubular right lens barrel 122R that holds the right lens 121R thereon. Similarly, the left optical unit 12L includes a left lens 121L that introduces image light from the display panel 13 to the left eye of the user, and a tubular left lens barrel 122L that holds the left lens 121L thereon. The right optical unit 12R and the left optical unit 12L are arranged in the rear of the display panel 13.

Further, the right lens barrel 122R and the left lens barrel 122L that are movable members may be supported in a movable manner relative to the main body housing 11. For example, it is sufficient if the right lens barrel 122R and the left lens barrel 122L may be supported in a movable manner in the leftward and rightward directions on the main body housing 11. This makes it possible for the user to adjust the distance between the right lens 121R and the left lens 121L in the leftward and rightward directions according to the distance between the left and right eyes of the user.

The mounting band 20 extends rearwardly from the apparatus main body 10. When the HMD 1 is used, the mounting band 20 surrounds the head H of the user. The mounting band 20 may have an annular shape such that the head H is arranged inside the annular mounting band 20. The mounting band 20 has a forehead rest portion 211 and a supporting portion 212 at a front portion thereof.

When the HMD 1 is used, the forehead rest portion 211 is applied to the front face of the head H of the user. A cushion may be provided on the inner face (rear face) of the forehead rest portion 211. Further, the inner face (rear face) of the forehead rest portion 211 may be curved so as to fit the front face of the head H.

The supporting portion 212 supports an upper portion of the main body housing 11. The supporting portion 212 may support the main body housing 11 in a movable manner in the forward and rearward directions. In particular, the supporting portion 212 that is a movable member may be provided on the main body housing 11 for forward and rearward movement relative to the main body housing 11. The supporting portion 212 may be fitted with a guide rail 11GL (refer to FIG. 7 hereinafter described) provided at an upper portion of the main body housing 11. By adopting such a configuration as just described, the user can adjust the position of the apparatus main body 10 in the forward and rearward directions in a state in which the HMD 1 is worn on the head H. Therefore, the user can adjust the distance (also called an eye relief) between the eyes of the user and the right lens 121R and the left lens 121L. It is to be noted that the guide rail 11GL may be built fixedly in the main body housing 11 so as not to be exposed to the exterior.

The light blocking member 30 is a member that is provided in order to block or reduce external light incident to the eyes of the user who wears the HMD 1. The light blocking member 30 may be provided at a rear portion of the main body housing 11 and may have an annular shape surrounding the right lens 121R and the left lens 121L as viewed from the rear. When the HMD 1 is used, the light blocking member 30 covers the eyes of the user. This makes it possible for the user to feel immersed with a high degree.

The light blocking member 30 may include a resin having elasticity. However, the light blocking member 30 is not limited to a member including a resin and may include, for example, a fibrous material (sponge or the like). The light blocking member 30 may be configured in such a manner as to be removably mounted on the main body housing 11 or may be formed in a fixed relation to the main body housing 11 by two-color molding or insert molding.

The light blocking member 30 includes at a lower portion thereof a nose accommodation portion 35 into which the nose of the user who wears the HMD 1 is to be accommodated. The nose accommodation portion 35 is part of the light blocking member 30 and is a portion that forms a space into which the nose of the user who wears the HMD 1 is to be accommodated. Further, as depicted in FIG. 1 and so forth, the main body housing 11 may have a concave portion 11b that is recessed forwardly so as to form part of the space into which the nose of the user is to be accommodated formed at a lower portion thereof.

As depicted in FIGS. 5 and 6, the nose accommodation portion 35 includes a right light blocking piece 35R configured to contact with the right side of the nose of the user and a left light blocking piece 35L configured to contact with the left side of the nose of the user. The nose of the user who wears the HMD 1 is accommodated into the space formed by the nose accommodation portion 35 through a slit between the right light blocking piece 35R and the left light blocking piece 35L. With such a configuration as described, it can be suppressed that external light enters from a gap between the nose of the user and the light blocking member 30 and then enters the eyes of the user.

### <Internal Structure of Apparatus Main Body 10>

Further, the internal structure of the apparatus main body 10 is described, mainly with reference to FIGS. 3, 4, 7, and 8. FIG. 7 is an exploded perspective view of a duct and members arranged around the duct as viewed diagonally from the front. FIG. 8 is an exploded perspective view of the duct and the members arranged around the duct as viewed diagonally from the rear. It is to be noted that, in FIG. 7, in order to illustrate a reason that the duct 50 has a bifurcated shape, the guide rail 11GL fixed to the main body housing 11 is depicted.

The apparatus main body 10 further includes a circuit board 14, a support wall 15, a duct 50, a heat sink 60, and a blower 70. The members mentioned are all accommodated in the main body housing 11.

The circuit board 14 has at least one or more electronic parts mounted thereon. In the following description, a face of the circuit board 14 on the side on which an integrated circuit 140 is mounted is referred to as a mounting face 141. In the present embodiment, the circuit board 14 is supported on the support wall 15 such that the mounting face 141 is directed forwardly in a state in which the HMD 1 is used. It is to be noted that the number and the arrangement of electronic parts to be mounted on the mounting face 141 are not limited to those depicted in FIG. 7.

The support wall 15 is a wall that defines a first space A1 that includes a space in which the right lens 121R and the left lens 121L are arranged and a second space A2 in which the duct 50 is arranged. The support wall 15 may support the circuit board 14 at a front portion thereof and may support the display panel 13 at a rear portion thereof. The circuit board 14 and the display panel 13 may be fixed directly to the support wall 15 or may be fixed indirectly to the support wall 15 through another member.

The support wall 15 may have an outer shape greater than that of the circuit board 14. In other words, the support wall 15 may be shaped so as to have a plate-shaped portion having a predetermined width in the forward and rearward directions and the leftward and rightward directions.

The duct 50 is a member that configures part of a flow path for discharging air in the main body housing 11 to the outside thereof. The duct 50 is arranged in front of the circuit board 14. The duct 50 has a bifurcated shape including one intake port and two exhaust ports. In particular, the duct 50 has a shape including an intake pipe portion 51 in which an intake port 51a is formed, a right exhaust pipe portion 52R in which a right exhaust port 52aR is formed, and a left exhaust pipe portion 52L in which a left exhaust port 52aL is formed.

The intake pipe portion 51 has a tubular shape and has a flow path through which air passes formed therein. The intake port 51a is formed at a lower portion of the intake pipe portion 51.

The right exhaust pipe portion 52R has a tubular shape and has a flow path through which air passes formed therein to be connected to the intake pipe portion 51 so as to extend diagonally to the upper right side with respect to the intake pipe portion 51. The right exhaust port 52aR is formed at an upper portion of the right exhaust pipe portion 52R. As depicted in FIG. 7 and so forth, a plurality of fins are arranged in the right exhaust port 52aR.

The left exhaust pipe portion 52L has a tubular shape and has a flow path through which air passes formed therein to be connected to the intake pipe portion 51 so as to extend diagonally to the upper left side with respect to the intake pipe portion 51. The left exhaust port 52aL is formed at an upper portion of the left exhaust pipe portion 52L. As depicted in FIG. 7 and so forth, a plurality of fins are arranged in the left exhaust port 52aL.

Further, as depicted in FIG. 2, a right through-hole 112R and a left through-hole 112L that are second through-holes are formed at an upper portion of the main body housing 11. The right through-hole 112R and the left through-hole 112L are formed avoiding the guide rail 11GL. In the present embodiment, the guide rail 11GL is provided substantially at the center of the main body housing 11 in the leftward and rightward directions. The right through-hole 112R is formed open so as to be directed forwardly on the right side with respect to the center of the main body housing 11 in the leftward and rightward directions. The left through-hole 112L is formed open so as to be directed forwardly on the left side with respect to the center of the main body housing 11 in the leftward and rightward directions.

The right exhaust pipe portion 52R of the duct 50 extends toward the right through-hole 112R. The left exhaust pipe portion 52L of the duct 50 extends toward the left through-hole 112L.

Further, as depicted in FIGS. 3 and 8, an opening 51b is formed at least at part of a rear portion of the intake pipe portion 51 of the duct 50. The heat sink 60 is provided in such a manner as to be fitted in the opening 51b. The heat sink 60 has a plate portion 61 that is fastened to the support wall 15 through the circuit board 14 by a fastening member such as a screw, and a plurality of heat dissipation fins 52 that project from the plate portion 61 in such a direction as to be away from the circuit board 14.

The heat sink 60 is arranged so as to radiate heat generated from the electronic parts mounted on the circuit board 14. The heat sink 60 is arranged so as to radiate heat of the integrated circuit 140 from which heat is likely to be generated. Further, the heat sink 60 is arranged on the flow path of air in the duct 50.

Further, the blower 70 is fitted in the intake port 51a. The blower 70 is arranged so as to suck air staying in the second space A2 and to send the air toward the right exhaust port 52aR and the left exhaust port 52aL through the inside of the duct 50.

As depicted in FIG. 3, the blower 70 includes a rotatable shaft portion 71, a vane portion 72 protruding to the outer side in a diametrical direction from the shaft portion 71, and a housing 73 that accommodates the shaft portion 71 and the vane portion 72 therein. The blower 70 is what is generally called an axial flow fan that sends air from one side to the other side in a direction in which the axial line x1 of the shaft portion 71 extends. The axial flow fan can be made in lower weight and send a greater amount of air in comparison with what is generally called a blower fan that sucks air from the side of the fan and sends the air forwardly. The blower 70 may electrically be connected to a predetermined electronic part mounted on the circuit board 14 such that it can be driven by the electric part.

As depicted in FIG. 3, the blower 70 is arranged such that the axial line x1 of the shaft portion 71 is inclined with respect to the mounting face 141 of the circuit board 14. In other words, the blower 70 is arranged such that the axial line x1 of the shaft portion 71 is inclined with respect to the optical axis x2 of the right lens 121R and the left lens 121L as viewed in side elevation.

Further, the blower 70 is arranged so as to send air toward the heat sink 60. In particular, the heat sink 60 is arranged on an extension line in the wind sending direction of the blower 70 as depicted in FIG. 3. Further, as depicted in FIG. 3 and so forth, each of heat dissipation fins 62 of the heat sink 60 may include an inclined portion 62a that is inclined in a direction same as the inclination direction of the housing 73 of the blower 70. By adopting such a shape as described, it is possible to arrange the blower 70 in the proximity of the heat sink 60. Since this makes it possible to use the blower 70 that is comparatively large while the space is effectively utilized, the air amount can be increased. As a result, the heat radiation effect of the heat sink 60 can be improved. Further, the space between the blower 70 and the front cover 111 can be made greater. Therefore, it becomes possible to effectively perform taking-in of air into the blower 70.

### <Flow of Air>

Now, a flow of air in the HMD 1 is described with reference to the drawings.

Air outside the HMD 1 enters the first space 1A through a gap between the face of the user and the light blocking member 30. Particularly, as depicted in FIGS. 1, 5, and 6, air outside the HMD 1 enters the first space 1A through the nose accommodation portion 35 that is open downwardly. A flow of the air at this time is indicated by a broken line arrow mark F1.

It is to be noted that the flow path of air that enters the first space 1A from the outside is not limited to that indicated by the broken line arrow mark F1. For example, air sometimes enters the first space 1A from the outside through a slit formed in the light blocking member 30. For example, as depicted in FIG. 5 and so forth, air sometimes enters the first space 1A from the outside through cutouts CR and CL that are formed in order to avoid interference of the temples of eyeglasses in a state in which the user wears the eyeglasses.

At least part of the air entering the first space 1A enters the apparatus main body 10 through a gap between the right lens barrel 122R that holds the right lens 121R thereon and the main body housing 11 and a gap between the left lens barrel 122L that holds the left lens 121L thereon and the main body housing 11. A flow of the air at this time is indicated by a broken line arrow mark F2 (refer to FIG. 5 and so forth).

It is to be noted that, as described hereinabove, the right lens barrel 122R and the left lens barrel 122L are attached to the main body housing 11 in a movable manner relative to the main body housing 11. In accordance with relative positions of the right lens barrel 122R and the left lens barrel 122L to the main body housing 11, the magnitude of each of the gaps between them and the position of each of the gaps change. For example, in a state in which the right lens barrel 122R and the left lens barrel 122L are positioned on the center side, the gap formed on the right side of the right lens barrel 122R is great, and the gap formed on the left side of the left lens barrel 122L is great. Through such comparatively great gaps, the air in the first space 1A enters the apparatus main body 10.

It is to be noted that entering of air into the apparatus main body 10 from the outside is not limited to that through the gaps between the main body housing 11 and the lens barrels that support the lenses thereon. For example, air sometimes enters the apparatus main body 10 through a gap between the supporting portion 212 of the mounting band 20, which is provided in a movable manner relative to the main body housing 11, and the main body housing 11. Accordingly, air enters the apparatus main body 10 through a plurality of locations in this manner, so that the circularity of air can further be improved.

Further, at least part of the air entering the apparatus main body 10 moves into the second space A2 through a through-hole formed in the support wall 15. Particularly, the air entering the apparatus main body 10 moves into the second space A2 through a right through-hole 151R that is a first through-hole in which a flexible circuit board 145R of the support wall 15 is fitted and a left through-hole 151L that is a first through-hole in which a flexible circuit board 145L of the support wall 15 is fitted.

As depicted in FIG. 7 and so forth, the right through-hole 151R is a vertically elongated hole formed at a right portion of the support wall 15, and the left through-hole 151L is a vertically elongated hole formed at a left portion of the support wall 15. The right through-hole 151R is formed on the right side with respect to a right edge of the circuit board 14. The left through-hole 151L is formed on the left side with respect to a left edge of the circuit board 14. In other words, the right through-hole 151R and the left through-hole 151L penetrate toward the front from the rear. The width of the right through-hole 151R in the leftward and rightward directions is greater than the thickness of the flexible circuit board 145R, and the width of the left through-hole 151L in the leftward and rightward directions is greater than the thickness of the flexible circuit board 145L.

As depicted in FIG. 2, the flexible circuit board 145R extends from the rear of the support wall 15 to the front of the support wall 15 through the right through-hole 151R and is electrically connected to a predetermined electronic part mounted on the circuit board 14. Similarly, the flexible circuit board 145L extends from the rear of the support wall 15 to the front of the support wall 15 through the left through-hole 151L and is electrically connected to a predetermined electronic part mounted on the circuit board 14.

It is to be noted that air in the first space 1A sometimes enters the second space A2 not only through the right through-hole 151R and the left through-hole 151L but also through another through-hole formed in the support wall 15 or a gap between an outer edge of the support wall 15 and the main body housing 11.

At least part of the air entering the second space A2 moves into the duct 50 through the intake port 51a of the duct 50 by driving of the blower 70. A flow of the air entering the second space A2 from the first space 1A and then moving into the duct 50 is indicated by a broken line arrow mark F3 (refer to FIG. 2).

The air moving into the duct 50 moves in the right exhaust pipe portion 52R or the left exhaust pipe portion 52L through the intake pipe portion 51 and is discharged to the outside of the duct 50 through the right exhaust port 52aR or the left exhaust port 52aL. The air discharged from the right exhaust port 52aR to the outside of the duct 50 is discharged to the outside of the apparatus main body 10 through the right through-hole 112R of the main body housing 11. Similarly, the air discharged from the left exhaust port 52aL to the outside of the duct 50 is discharged to the outside of the apparatus main body 10 through the left through-hole 112L of the main body housing 11. Since the heat moves upwardly, the heated air can be discharged efficiently through the right through-hole 112R and the left through-hole 112L formed at an upper portion of the main body housing 11. A flow of air at this time is indicated by a broken line arrow mark F4 (refer to FIG. 2 and so forth).

### <Summary>

In the HMD 1 according to the present embodiment described above, it is possible to move air entering the first space 1A and staying in the first space 1A into the apparatus main body 10. Particularly, in the HMD 1, since the blower 70 is accommodated in the main body housing 11, air on the outside can be taken positively into the apparatus main body 10 by driving of the blower 70. As a result, the ventilation performance is improved, and even in a case where the humidity becomes high by perspiration of the user or the like, the user can use the HMD 1 comfortably.

Further, since heat of the electronic parts mounted on the circuit board 14 is radiated from the fins 62 of the heat sink 60 and air is sent toward the circuit board 14 and the heat sink 60 from the blower 70, a rise of the temperature of the electronic parts can be suppressed. Further, since the duct 50 configures a flow path through which air is discharged din the main body housing 11 to the outside thereof, air in the main body housing 11 can be discharged efficiently to the outside. Further, since the duct 50 configures a flow path for air, it is possible to circulate the air in the apparatus main body 10. Therefore, a rise of the temperature of the electronic parts can be suppressed more efficiently. As a result, a temperature size in the apparatus main body 10 can be suppressed efficiently.

### <Others>

Although the present embodiment indicates an example in which heat of the electronic parts is radiated with use of the heat sink 60, this is not limited to this example, and the heat sink 60 may not be included.

Further, although the present embodiment indicates an example in which the duct 50 and the blower 70 are formed integrally, this is not limited to this example, and the duct 50 and the blower 70 may be formed as separate members and arranged apart from each other. Further, also the blower 70 is not essentially required, and it is sufficient if such a configuration that at least a flow path through which air can be discharged to the outside of the main body housing 11 is formed is applied.

Furthermore, a configuration which does not include the duct 50 and in which air in the second space A2 is discharged to the outside of the main body housing 11 by driving of the blower 70 may be applied. In this case, for example, the blower 70 may be fixed to the inner wall of the main body housing 11. Also in such a configuration as described, it is possible to send air in the first space 1A in which the face of the user is arranged to the second space A2 and to discharge the air from the second space A2 to the outside of the main body housing 11. As a result, the ventilation performance can be improved, and it is possible for the user to use the HMD 1 comfortably.

It is to be noted that, although an example in which an electronic part mounted on the circuit board 14 is a heat source has been described in the present embodiment, another electronic part that serves as a heat source may be built in the apparatus main body 10. Since the present embodiment adopts a configuration in which air is circulated in the main body housing 11, a temperature rise can be suppressed also in regard to an electronic part other than an electronic part to which air is applied directly from the blower 70.

## Claims

1. A head-mounted display comprising:
a main body housing that accommodates at least a display panel and a lens therein;
a mounting band that supports the main body housing and that is mounted on a head of a user; and
a duct accommodated in the main body housing and configuring part of a flow path that discharges air in the main body housing to an outside thereof.

2. The head-mounted display according to claim 1, further comprising:
a blower accommodated in the main body housing and configured to discharge air in the main body housing to the outside of the main body housing through the duct.

3. The head-mounted display according to claim 2, further comprising:
a circuit board accommodated in the main body housing and having an electronic part mounted thereon, wherein
the blower is arranged so as to send air toward the electronic part.

4. The head-mounted display according to claim 2 or 3, wherein
the blower includes a rotatable shaft portion and a vane portion extending from the shaft portion and is arranged such that an axial line of the shaft portion extends in a manner being inclined to the circuit board.

5. The head-mounted display according to any one of claims 2 to 4, further comprising:
a heat sink that radiates heat generated from the electronic part, wherein
the blower is arranged so as to send air toward the heat sink.

6. The head-mounted display according to claim 5, wherein
the heat sink is arranged on the flow path of the duct.

7. The head-mounted display according to any one of claims 2 to 6,
wherein
the blower is arranged in an intake port of the duct.

8. The head-mounted display according to any one of claims 2 to 7, further comprising:
one or a plurality of movable members provided in the main body housing in a movable manner relative to the main body housing, wherein the blower is arranged so as to discharge air, which enters the main body housing from the outside through a gap between the main body housing and the movable members, to the outside of the main body housing through the duct.

9. The head-mounted display according to claim 8, wherein
the one or plurality of movable members include a supporting portion that is part of the mounting band and that is connected to an upper portion of the main body housing and supports the main body housing.

10. The head-mounted display according to claim 8 or 9, wherein
the one or plurality of movable members include a lens barrel that holds the lens.

11. The head-mounted display according to any one of claims 1 to 10, further comprising:
a support wall that defines a first space including a space in which the lens is arranged and a second space in which the duct is arranged,
wherein
the support wall has formed therein a first through-hole that serves as a flow path of air that flows from the first space to the second space.

12. The head-mounted display according to claim 11, further comprising:
a flexible circuit board fitted in the first through-hole and
electrically connected to a predetermined electronic part mounted on a circuit board.

13. The head-mounted display according to any one of claims 1 to 12,
wherein
a second through-hole is formed at an upper portion of the main body housing, and
the duct includes a portion that extends toward the second through-hole.

14. The head-mounted display according to claim 13, wherein
the mounting band includes a supporting portion that is connected to an upper portion of the main body housing to support the main body housing thereon,
the main body housing has formed at an upper portion thereof a second right through-hole and a second left through-hole that is positioned on an opposite side to the first opening across the supporting portion, and
the duct includes a right discharge pipe portion extending toward the second right through-hole and a left discharge pipe portion extending toward the second left through-hole.
